# EUROPEAN PATENT SPECIFICATION

(11) **EP 2 417 286 B1**
(45) Date of publication and mention of the grant of the patent: **20.05.2015**
(21) Application number: 10762037.9
(22) Date of filing: 26.02.2010
(51) Int. Cl.: D01C 5/00, D01F 9/12

(54) **APPARATUS AND METHOD FOR THE PRODUCTION OF CARBON NANOTUBES ON A CONTINUOUSLY MOVING SUBSTRATE**
VORRICHTUNG UND VERFAHREN ZUR HERSTELLUNG VON KOHLENSTOFFNANORÖHRCHEN AUF EINEM KONTINUIERLICH BEWEGTEN SUBSTRAT
APPAREIL ET PROCÉDÉ DE PRODUCTION DE NANOTUBES DE CARBONE SUR UN SUBSTRAT AVANÇANT EN CONTINU

(30) Priority: 10.04.2009 US 168516 P; 15.01.2010 US 295624 P
(43) Date of publication of application: 15.02.2012
(73) Proprietor: Applied Nanostructured Solutions, Inc., Baltimore, MD 21220 (US)
(72) Inventor: MALECKI, Harry, C., Abingdon MD 21009 (US); LOEBACH, James, P., Bel Air MD 21015 (US); SHAH, Tushar, K., Fulton, MD 20759 (US); ALBERDING, Mark, R., Glen Arm MD 21057 (US); BRAINE, Jack, K., Columbia MD 21045 (US); LARUE, John, A., Bel Air MD 21014 (US)
(74) Representative: Epping, Wilhelm
(86) International application number: PCT/US2010/025660
(87) International publication number: WO 2010/117515

(56) References cited:
- WO-A1-2006/107144
- WO-A1-2008/153609
- WO-A1-2009/155451
- WO-A1-2010/081769
- GB-A- 2 458 776
- US-A1- 2004 037 767
- US-A1- 2008 178 924
- HART ET AL.: 'Rapid Growth and Flow-Mediated Nucleation of Millimeter-Scale Aligned Carbon Nanotube Structures from a Thin-Film Catalyst.' JOURNAL OF PHYSICAL CHEMISTRY: B vol. 110, no. ISS 6, 11 March 2006, pages 8250 - 8257, XP002458344
- SINGH ET AL.: 'Production of controlled architectures of aligned carbon nanotubes by an injection chemical vapour déposition method.'' CARBON vol. 41, no. 2, 07 December 2002, pages 359 - 368, XP004397239
- CAO ET AL.: 'MEDIUM-SCALE CARBON NANOTUBE THIN-FILM INTEGRATED CIRCUITS ON FLEXIBLE PLASTIC SUBSTRATES' NATURE vol. 454, no. 7203, 24 July 2008, pages 495 - 500, XP055068838
- ANDREWS ET AL.: 'Continuous production of aligned carbon nanotubes: a step closer to commercial realization.' CHEMICAL PHYSICS LETTERS vol. 303, no. 5, 16 April 1999, pages 467 - 474, XP002232174

## Description

### FIELD OF THE INVENTION

The present invention relates in general to an apparatus and method for the production of carbon nanotubes on a continuously moving substrate.

### BACKGROUND OF THE INVENTION

As used herein, the term "carbon nanotube" (CNT, plural CNTs) refers to any of a number of cylindrically-shaped allotropes of carbon of the fullerene family including single-walled carbon nanotubes (SWNTs), double-walled carbon nanotubes (DWNTs), multi-walled carbon nanotubes (MWNTs). CNTs can be capped by a fullerene-like structure or openended. CNTs include those that encapsulate other materials. Carbon nanotubes exhibit impressive physical properties. The strongest CNTs exhibit roughly eighty times the strength, six times the toughness (i.e., Young's Modulus), and one-sixth the density of high carbon steel.

GB 2458776 A discloses a thermal CVD process for growing carbon structures on a continuous substrate that is moved into and out of a deposition chamber. WO 2006/107144 discloses a mass production system and method for synthesizing carbon nanotubes. WO 2008/153609 A1 discloses a scaled method for producing substantially aligned carbon nanotubes by depositing onto a continuously moving substrate. Current carbon nanotube (CNT) synthesis techniques can provide bulk quantities of "loose" CNTs for use in a variety of applications. These bulk CNTs can be used as a modifier or dopant in composite systems, for example. Such modified composites typically exhibit enhanced properties that represent a small fraction of the theoretical improvements expected by the presence of CNTs. The failure to realize the full potential of CNT enhancement is related, in part, to the inability to dope beyond low percentages of CNTs (1-4%) in the resulting composite along with an overall inability to effectively disperse the CNTs within the structure. This low loading, coupled with difficulties in CNT alignment and CNT-to-matrix interfacial properties figure in the observed marginal increases in composite properties, such as mechanical strength, compared to the theoretical strength of CNTs. Besides the physical limitation of bulk CNT incorporation, the price of CNTs remain high due to process inefficiencies and post processing required to purify the end CNT product.

One approach to overcome the above deficiencies, would be to develop techniques that grow CNTs directly on useful substrates, such as fibers, which can be used to organize the CNTs and provide a reinforcing materials in a composite. Attempts have been made to grow CNTs in a nearly continuous fashion, however, none have been successful such that they operate continuously, roll to roll without batch-wise processing. The present invention provides an apparatus and method that allows for continuous production of CNTs on a variety of substrates and provides related advantages as well.

Some processes attempt to grow CNTs directly on fiber substrates; illustrative thereof is the process disclosed in U.S. Pat. No. 7,338,684 to Curliss et al. This patent discloses a method for producing vapor-grown carbon-fiber-reinforced composite materials. According to the patent, a catalyst precursor such as a ferric nitrate solution is applied as a coating to fiber preform. The coated preform is then heated in air, typically at a temperature in the range of 300 °C to 800 °C, to decompose the precursor and yield an oxidized catalyst particle. Some of the examples disclose a heating time of 30 hrs. To reduce the catalyst particle to a metallic state, the preform is exposed to a flowing gas mixture including hydrogen. This is typically performed at a temperature of 400 °C. to 800 °C for a period of time in the range of about 1 hour to about 12 hours.

Vapor grown carbon fiber (i.e., CNTs) is produced by contacting a gas phase hydrocarbon gas mixture with the preform at a temperature between about 500 °C to 1200 °C. According to the patent, the fibers grow on the composite preform resulting in a tangled mass of carbon fiber (carbon nanotubes). The reaction time for growth varies between 15 minutes and 2 hours, primarily as a function of feed gas composition and temperature.

The processing times for the approach disclosed in 7,338,684 are too long for efficient processing. Furthermore, due to the extreme variation in the processing time for various steps, the process is unsuitable for implementation as a continuous processing line for the production of carbon nanotubes on a continuously moving substrate.

### SUMMARY OF THE INVENTION

In some aspects, embodiments disclosed herein relate to an apparatus capable of linear and/or continuous CNT synthesis on spoolable length substrates. The apparatus comprises a first end having a substrate inlet sized to allow a spoolable length substrate to pass therethrough, wherein the substrate includes any material upon which carbon nanotubes can be synthesized and has at least one dimension that is not limited in length. The apparatus includes a preheated first purge zone comprising a purge gas inlet and a cooled second purge zone comprising a purge gas inlet. The apparatus includes at least one carbon nanotube growth zone disposed between the first and second purge zone, wherein within the carbon nanotube growth zone a catalyst reduction and carbon nanotube growth occur. The apparatus also includes at least one heater in thermal communication with the carbon nanotube-growth zone heating the carbon nanotube growth zone such that the temperature is in the range of 550 °C to 850 °C; and at least one feed gas inlet in fluid communication with the carbon nanotube growth zone and proximate to the center of the carbon nanotube growth zone. The apparatus comprises a second end having a substrate outlet sized to allow the spoolable length substrate to pass therethrough. The apparatus is open to the atmosphere during operation. The CNT growth is carried out at ambient or near ambient pressures. The apparatus is designed to be integrated into a system for the continuous growth of carbon nanotubes.

### BRIEF DESCRIPTION OF THE DRAWINGS

Figure 1 shows a simplified perspective view of an apparatus for the synthesis of CNTs in a continuous process in accordance with an embodiment of the present invention.
Figure 2 shows a simplified cross-sectional side view of an apparatus for the synthesis of CNTs in a continuous process in accordance with an illustrative embodiment of the present invention.
Figure 3 shows a cross-sectional side view of an embodiment of an apparatus in accordance with the present invention.
Figure 4 shows a cross-sectional side view of an embodiment of an apparatus in accordance with the present invention.
Figure 5 shows a top cross-sectional view of the apparatus of Figure 3 in accordance with the present invention.
Figure 6 shows a top cross-sectional view of an embodiment of an apparatus in accordance with the present invention.
Figure 7 shows a transverse side view of another embodiment of an apparatus in accordance with the present invention.
Figure 8 shows a transverse top view of the embodiment of Figure 7.
Figure 9 shows a longitudinal top cross sectional view of the embodiment of Figure 7.
Figure 10 shows a longitudinal side cross sectional view of the embodiment of Figure 7.
Figure 11 shows a longitudinal top view of the embodiment of Figure 7.
Figure 12 is a side cross-sectional view of the embodiment of Figure 7.

### DETAILED DESCRIPTION

The present invention relates in general to an apparatus and method for the production of carbon nanotubes on a continuously moving substrate. In accordance with some embodiments, apparatus 100 is used to grow, produce, deposit, or otherwise generate CNTs in situ directly onto or into moving substrate 106 and takes the form of an open ended, atmospheric, to slightly higher than atmospheric pressure, small cavity, chemical vapor deposition (CVD) CNT growth system. In accordance with the illustrative embodiment, CNTs are grown via CVD at atmospheric pressure and at elevated temperature (typically in the range of about 550 °C to about 800 °C in a multi-zone apparatus **100.** The fact that the synthesis occurs at atmospheric pressure is one factor that facilitates the incorporation of apparatus **100** into a continuous processing line for CNT-on-fiber synthesis. The fact that CNT growth occurs in seconds, as opposed to minutes (or longer) in the prior art, is another feature that enables using the apparatus disclosed herein in a continuous processing line. CNT-synthesis can be performed at a rate sufficient to provide a continuous process for functionalizing spoolable substrates. Numerous apparatus configurations facilitate such continuous synthesis.

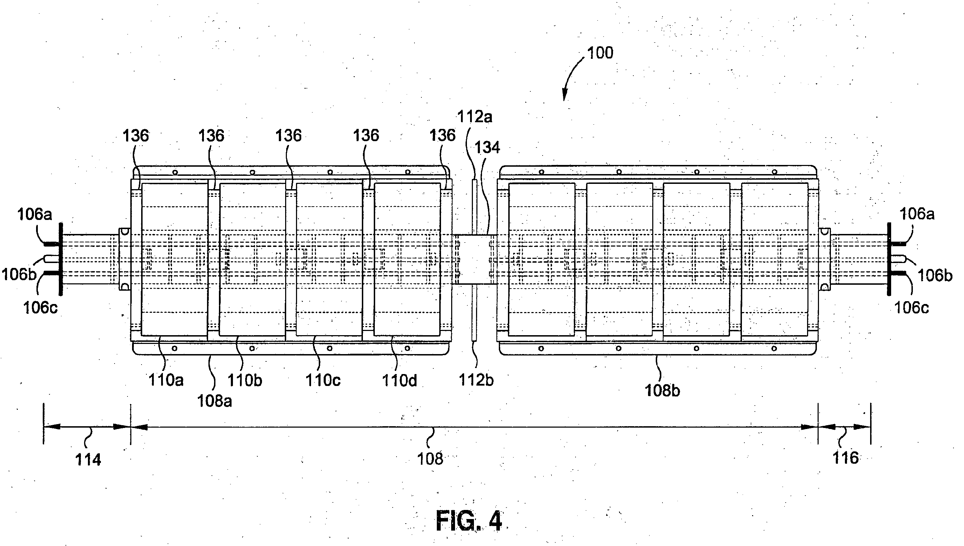

Apparatus **100** includes at least one CNT growth zone **108** equipped with growth heaters **110** disposed between two quench or purge zones **114, 116.** Any number of growth heaters can be included, (e.g., heaters **110a, 110b, 110c, 110d** of Figure 4). Apparatus **100** optionally includes pre-heater **132** that pre-heats feed gas **128** and feed gas diffuser **136** to distribute feed gas **128.**

In order to realize the potential enhancement afforded by CNT introduction into various materials and applications, an apparatus for applying CNTs directly to substrate surfaces is disclosed herein. CNTs applied directly on substrate surfaces, particularly in the case of silicon wafers or composite fiber materials, improves overall CNT dispersion, placement, and alignment in the completed structure. In the case of composite materials, the incorporation of CNTs on the fiber or fabric level improves CNT loading by having the CNTs preordered and placed in the composite structure, instead of having to dope resins with loose CNTs. To grow CNTs directly on a substrate in a continuous process improves not only these physical characteristics but also reduces overall CNT cost. By having CNTs grown directly on the final useful substrate surface, the auxiliary costs involved with CNT purification and doping/mixing/placement/dispersion are removed.

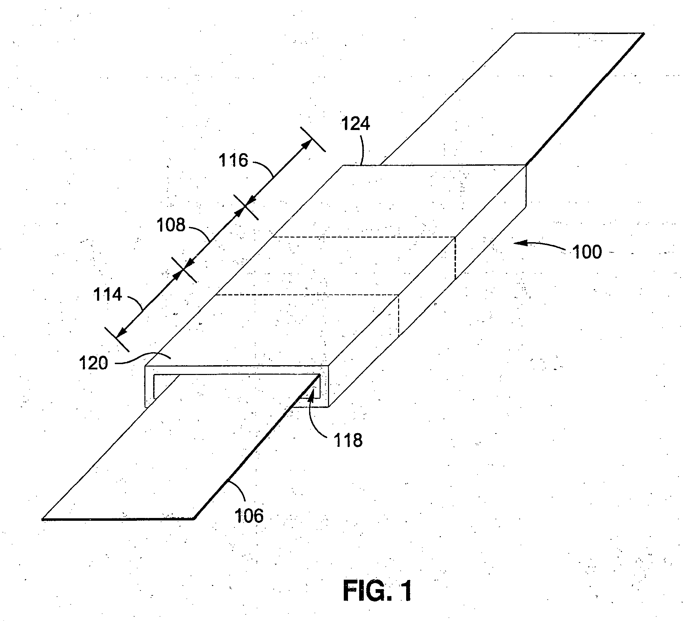

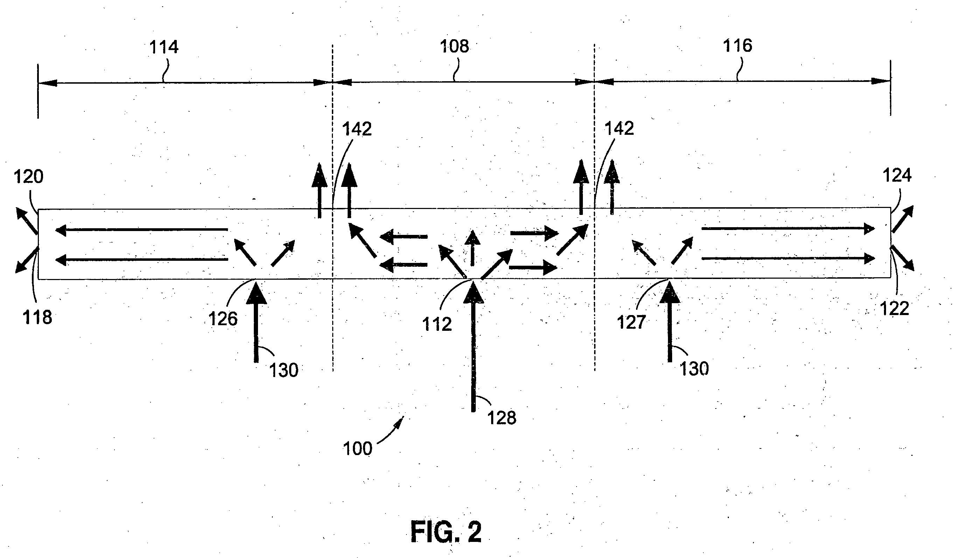

Referring to Figure 1, apparatus 100 can include substrate inlet **118** sized to allow spoolable length substrate **106** to continually pass therethrough, allowing for the synthesis and growth of CNTs directly on substrate **106.** Apparatus **100** can be a multi-zone apparatus with seed or CNT growth zone **108** between a pre-process purge or first purge zone **114** and a post-process purge or second purge zone **116.** Apparatus **100** is open to the atmosphere during operation, with first end **120** and second end **124,** such that substrate **106** enters apparatus 100 through substrate inlet **118** in first end **120,** passes through first purge zone **114,** CNT growth zone **108, second** purge zone **116** and out through substrate outlet **122** (shown in Figure 2) in second end **124.** In some embodiments, the CNT growth system can include additional zones that are specifically designed to activate catalyst particles via reduction reactions. In such embodiments, a catalyst activation zone can be placed between first purge zone **114** and CNT growth zone **108.**

Apparatus **100** allows for the seamless transfer of substrate **106** into and out of CNT growth zone **108,** obviating the need for batch runs. Spoolable length substrate **106** effectively passes through an equilibrated growth system which has established optimal conditions for rapid CNT growth in real time as substrate **106** continually moves through a system that begins with spoolable length substrate **106** and winds the finished product at the end at CNT infusion on substrate **106.** The ability to do this continuously and efficiently, while controlling parameters such as CNT length, density, and other characteristics has not been previously achieved.

In some embodiments, a continuous process for infusion of CNTs on spoolable substrates can achieve a linespeed between about 0.5 ft/min (about 0.15 m/min) to about 36 ft/min (about 11 m/min). In this embodiment where CNT growth zone **108** is 3 feet long and operating at a 750 °C growth temperature, the process can be run with a linespeed of about 6 ft/min (about 1.83 m/min) to about 36 ft/min (about 11 m/min) to produce, for example, CNTs having a length between about 1 micron to about 10 microns. The process can also be run with a linespeed of about 1 ft/min (about 0.3 m/min) to about 6 ft/min (about 1.83 m/min) to produce, for example, CNTs having a length between about 10 microns to about 100 microns. The process can be run with a linespeed of about 0.5 ft/min (about 0.15 m/min) to about 1 ft/min (about 0.3 m/min) to produce, for example, CNTs having a length between about 100 microns to about 200 microns. The CNT length is not tied only to linespeed and growth temperature, however, the flow rate of both the feed gas and inert carrier gases can also influence CNT length. For example, a flow rate consisting of less than 1% carbon feedstock in inert gas at high linespeeds (6 ft/min to 36 ft/min; i.e. about 1.83 m/min to about 11 m/min) will result in CNTs having a length between 1 micron to about 5 microns. A flow rate consisting of more than 1% carbon feedstock in inert gas at high linespeeds (6 ft/min to 36 ft/min; i.e. about 1.83 m/min to about 11 m/min) will result in CNTs having length between 5 microns to about 10 microns. Resulting growth rates for this continuous CNT growth system range depending on temperature, gases used, substrate residence time, and catalyst, however, growth rates on the range of 0.01-10 microns/second are possible.

CNT growth zone **108** can be an open-air continuous operation, flow-through chamber. CNT growth zone **108** can be formed or otherwise bound by a metal enclosure such as stainless steel, titanium, carbon steel, or other high temperature metal or mixtures thereof, with additional features added to improve structural rigidity as well as reduce thermal warping due to repeated heat cycling. CNT growth zone **108** can be circular, rectangular, oval, or any number of polygonal or other geometrical variant cross-section based on the profile and size of substrate passing therethrough.

An internal volume of CNT growth zone **108** can be compared with a volume of substrate **106** having a length substantially equal to a length of CNT growth zone **108.** In some embodiments, CNT growth zone **108** is designed to have an internal volume of no more than about 10000 times greater than the volume of substrate **106** disposed within CNT growth zone **108.** In most embodiments, this number is greatly reduced to no more than about 4000 times. In other embodiments, this can be reduced to about 3000 times or less. Similarly, cross sectional areas of CNT growth zone **108** can be limited to about 10000, 4000, or 3000 times greater than a cross sectional area of substrate **106.** Without being bound by theory, reducing the size of CNT growth zone **108** ensures high probability interactions between feed gas **128** and substrates coated with catalyst particles. Larger volumes result in excessive unfavorable reactions as the treated substrate is only a small fraction of the available volume. CNT growth zone **108** can range from dimensions as small as millimeters wide to as large as over 1600 mm wide. CNT growth zone **108** can have a rectangular cross-section and a volume of about 0.27 cubic feet (about 0.008 cubic meters). Temperature in CNT growth zone **108** can be controlled with imbedded thermocouples strategically placed on an interior surface thereof. Since CNT growth zone **108** is so small, the temperature of the enclosure is nearly the same temperature as the CNT growth zone **108** and gases inside. CNT growth zone **108** can be maintained at about 550° C.

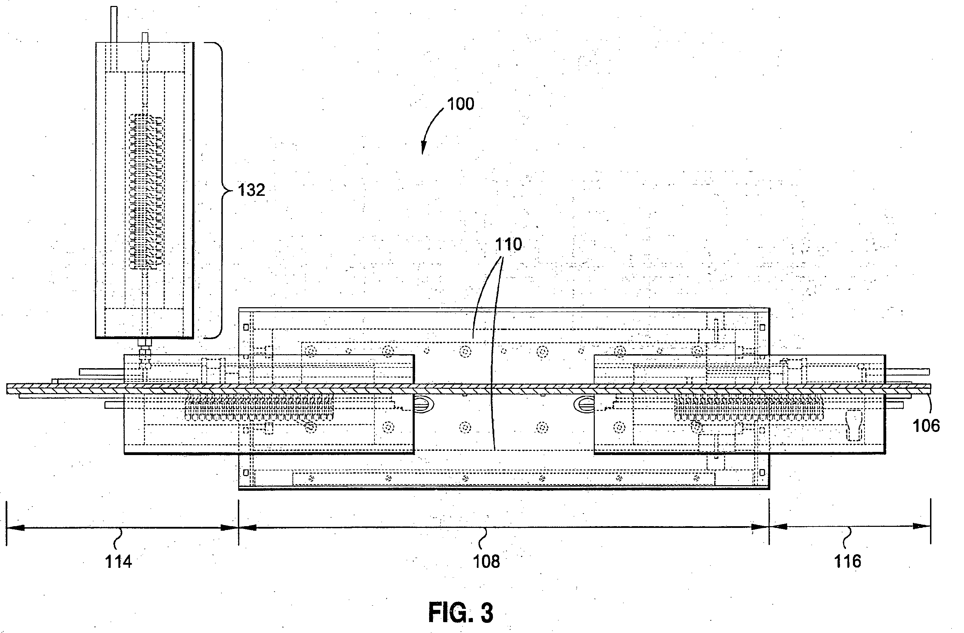

Referring now to Figure 2, Figure 3, and Figure 4, both purge zones **114, 116** provide the same function. As feed gas **128** (shown in Figure 2) from CNT growth zone **108** exits apparatus **100,** purge zones **114, 116** supply a continuous flow of purge gas **130** (shown in Figure 2) to buffer CNT growth zone **108** from the external environment. This can include optionally preheating purge zone **114** and/or cooling purge zone **116.** This helps to prevent unwanted mixing of feed gas **128** with the outside atmosphere, which could cause unintended oxidation and damage to substrate **106** (shown in Figure 3 and Figure 4) or CNT material. Purge zones **114, 116** are insulated from CNT growth zone **108** to prevent excessive heat loss or transfer from heated CNT growth zone **108.** In some embodiments, one or more exhaust ports **142** (shown in Figure 2) are placed between purge zones **114, 116** and CNT growth zone **108.** In such embodiments, gas does not mix between CNT growth zone **108** and purge zones **114, 116,** but instead exhausts to the atmosphere through ports **142.** This also prevents gas mixing which is important in situations where multiple CNT growth zones **108** (e.g., **108a, 108b** in Figure 4) can be used in series, attached, or otherwise utilized together to extend the overall effective CNT growth zone. Purge zones **114, 116** in this embodiment still provide a cool gas purge to ensure reduced temperatures as substrate **106** enters/exits CNT growth zone **108.**

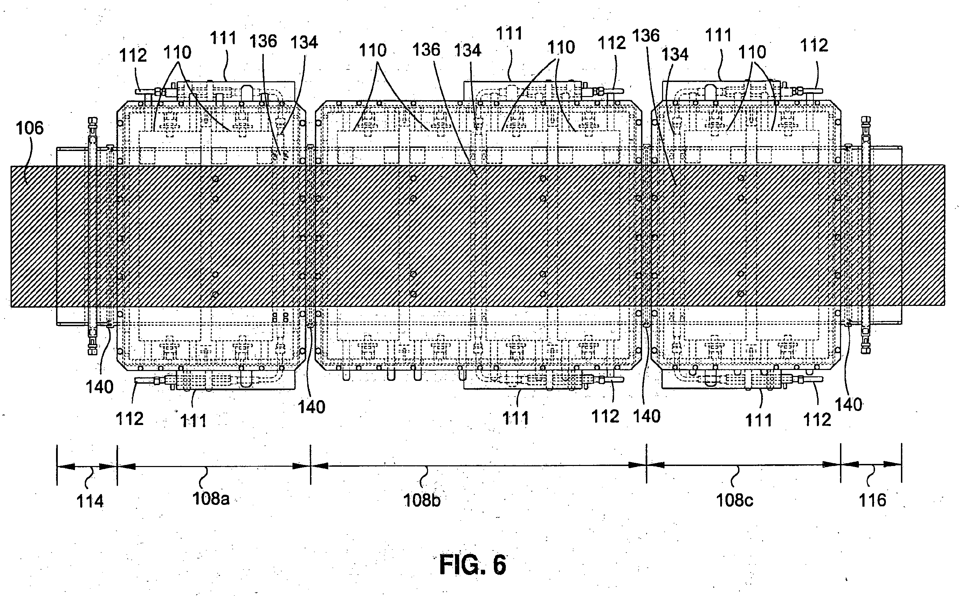

Feed gas **128** can enter CNT growth zone **108** of apparatus **100** via one or more feed gas inlets **112** (e.g., **112a** and **112b** of Figure 4). Feed gas **128** can pass through feed gas inlet manifold **134** (shown in Figure 4) and into CNT growth zone **108** via feed gas diffusers **136** (shown in Figure 4). Feed gas **128** can react with seeds present on or in substrate **106** to create CNTs, with any leftover feed gas **128** passing through exhaust manifold **140** (shown in Figure 6) or otherwise exit CNT growth zone **108.** Purge gas **130** can be used to prevent the hot gases inside CNT growth zone **108** from mixing with the oxygen rich gas outside CNT growth zone **108** and creating local oxidizing conditions that could adversely affect substrate **106** entering or exiting CNT growth zone **108.** Purge gas **130** can enter purge zones **114, 116** of apparatus **100** at purge gas inlets **126, 127** (shown in Figure 2), allowing for a buffer between CNT growth zone **108** and the external environment. Purge gas **130** can prevent ambient gasses from entering CNT growth zone **108,** and can either exit through substrate inlet **118** or substrate outlet **122** at respective ends **120, 124** of apparatus **100** as indicated in Figure 2, or purge gas **130** can exit through exhaust manifold **140** (shown in Figure 6).

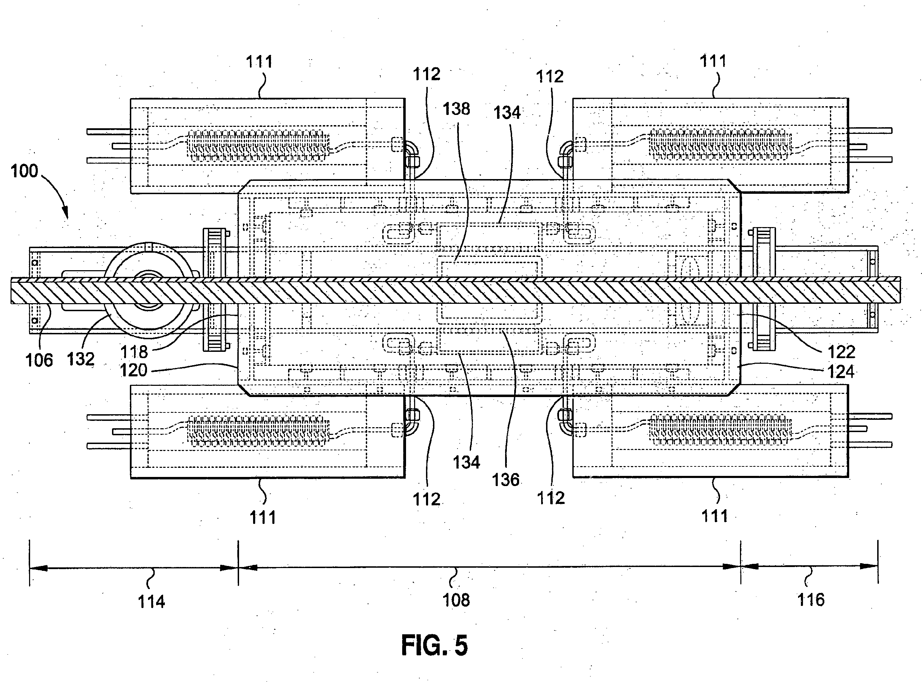

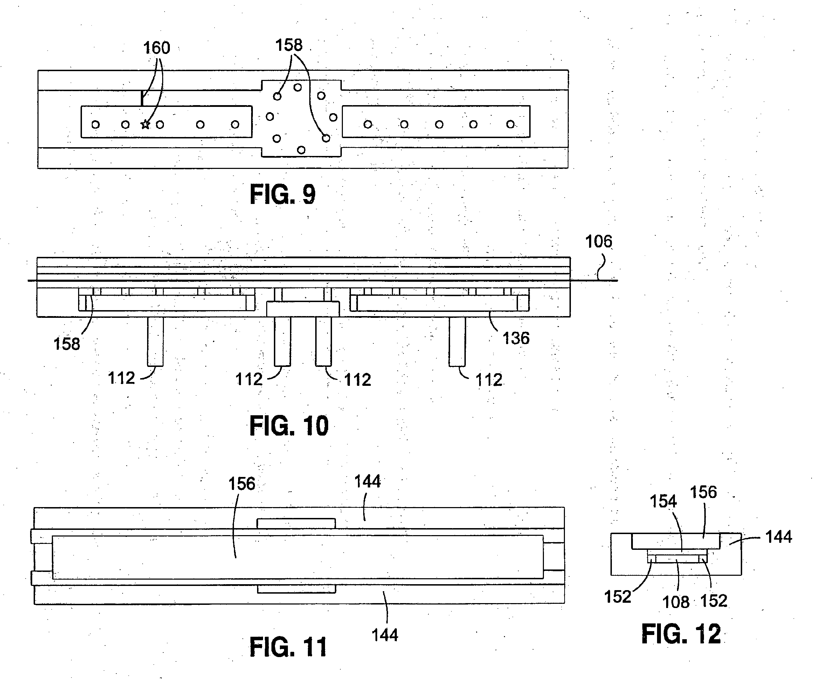

Purge gas preheater **132** (shown in Figure 3) can preheat purge gas **130** prior to introduction into first purge zone **114.** CNT growth zone **108** can be further heated by heaters **110** (shown in Figure 3) contained within CNT growth zone **108.** As illustrated, heaters **110** are on either side of substrate **106.** However, heaters **110** can be anywhere within CNT growth zone **108,** either placed along the length or in cases of wide systems, along the width of CNT growth zone **108,** to ensure isothermal heating for well controlled CNT growth processes. Heaters **110** can heat CNT growth zone **108** and maintain an operational temperature at a pre-set level. Heaters **110** can be controlled by a controller (not shown). Heaters **110** can be any suitable device capable of maintaining CNT growth zone **108** at about the operating temperature. Alternatively, or additionally, heaters **111** (shown in Figure 5 and Figure 6) can preheat feed gas **128.** Any of heaters **110, 111, 132** can be used in conjunction with CNT growth zone **108,** so long as the particular heater is in thermal communication with CNT growth zone **108.** Heaters **110, 111, 132 can** include long coils of gas line heated by a resistively heated element, and/or series of expanding tubes to slow down and which is then heated via resistive heaters (e.g., infrared heaters). Regardless of the method, gas can be heated from about room temperature to a temperature suitable for CNT growth, e.g. from about 25 °C to about 800 °C. In some instances, heaters **110, 111,** and/or **132** can provide heat such that the temperature within CNT growth zone **108** is about 550 °C to about 850 °C or up to about 1000 °C. Temperature controls (not shown) can provide monitoring and/or adjustment of temperature within CNT growth zone **108**. Measurement can be made at points (e.g., probe **160** of Figure 9) on plates or other structures defining CNT growth zone **108.** Because the height of CNT growth zone **108** is relatively small, the temperature gradient between the plates can be very small, and thus, measurement of temperature of the plates can accurately reflect the temperature within CNT growth zone **108.**

Because substrate **106** has a small thermal mass, as compared with CNT growth zone **108,** substrate **106** can assume the temperature of CNT growth zone **108** almost immediately. Thus, preheat can be left off to allow room temperature gas to enter the growth zone for heating by heaters **110.** In some embodiments, only purge gas is preheated. Other feed gas can be added to purge gas after purge gas preheater **132.** This can be done to reduce long term sooting and clogging conditions that can occur in purge gas preheater **132** over long times of operations. Preheated purge gas can then enter feed gas inlet manifold **134.**

Feed gas inlet manifold **134** provides a cavity for further gas mixing as well as a means for dispersing and distributing gas to all gas insertion points in CNT growth zone **108.** These points of insertion are built into one or more feed gas diffusers **136,** e.g. gas diffuser plates with a series of patterned holes. These strategically placed holes ensure a consistent pressure and gas flow distribution. Feed gas enters CNT growth zone **108,** where heaters **110** can apply an even temperature generation source.

Referring now to Figure 5, in one exemplary embodiment, substrate **106 enters** first purge zone **114,** where purge gas **130,** which has been preheated by purge gas preheater **132** warms substrate **106** while simultaneously preventing ambient air from entering CNT growth zone **108.** Substrate **106** then passes through substrate inlet **118** in first end **120** of CNT growth zone **108.** As illustrated in Figure 5 and Figure 6, substrate **106** enters CNT growth zone **108, is** heated by heaters **110** (shown in Figure 6) and exposed to feed gas **128** (shown in Figure 2). Before entering CNT growth zone **108,** feed gas **128** can move from any of heaters **111,** through any of feed gas inlets **112,** through feed gas inlet manifold **134,** and through feed gas diffusers **136.** Feed gas **128** and/or purge gas **130** can exit first purge zone **114** and/or CNT growth zone **108** via exhaust ports **142** and/or exhaust manifold **140,** maintaining atmospheric or slightly above atmospheric pressure. Substrate **106** can continue through additional CNT growth zones **108** as desired until sufficient CNT growth has occurred. As illustrated in Figure 5, substrate **106** passes through substrate outlet **122** in second end **124** of CNT growth zone **108** and into second purge zone **116.** Alternatively, first purge zone **114** and second purge zone **116** can be the same zone and substrate **106** can turn around within apparatus **100** and pass out of CNT growth zone **108** via substrate inlet **118.** In either event, substrate passes into a purge zone and out of apparatus **100.** Purge zones **114** and **116** can each have purge gas introduced through purge gas inlet **126** and **127** (shown in Figure 2), such that purge gas **130** therein acts as a buffer and prevents feed gas **128** from contacting ambient air. Likewise, purge zones **114** and **116** can each have exhaust ports **142** (shown in Figure 2) and/or exhaust manifolds **140** (shown in Figure 6) to accomplish appropriate buffering. Access plate **138** (shown in Figure 5) can provide access to CNT growth zone **108,** for cleaning and other maintenance.

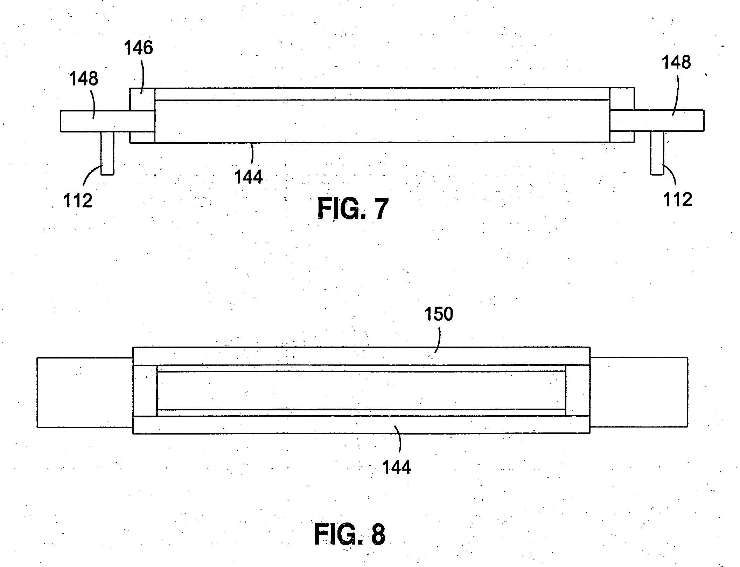

Referring now to Figures 7-12, in one embodiment, CNT growth zone 108 can be constructed from skirt 144, piped connection 146, and plugged connection 148. Insulation, such as gas seal insulation 150 can provide a barrier to the external environment. Stainless steel standoffs 152 can support copper plate 154, which can in turn support quartz lens 156. As with the embodiments described above, feed gas can enter CNT growth zone 108 via gas ports 158 and temperature can be monitored by probe 160. While the embodiment illustrated in Figures 7-12 is functional, the embodiments described above are preferred at the time of filing.

In some embodiments, multiple substrates **106** (e.g., **106a, 106b, 106** c in Figure 4) can pass through apparatus **100** at any given time. Likewise, any number of heaters can be used either inside or outside a particular CNT growth zone **108.**

Some of potential advantages of the apparatus and method of the present teachings can include, without limitation: improved cross-sectional area; improved zoning; improved materials; and combined catalyst reduction and CNT synthesis.

Since most of the material processed is relatively planar (e.g., flat tape or sheet-like form), the conventional circular cross-section is an inefficient use of volume. Such circular cross-section can create difficulties with maintaining a sufficient system purge, because an increased volume requires increased purge gas flow rates to maintain the same level of gas purge. Thus, the conventional circular cross-section is inefficient for high volume production of CNTs in an open environment. Further such circular cross-section can create a need for increased feed gas flow. The relative increase in purge gas flow requires increased feed gas flows. For example, the volume of a 12K fiber is 2000 times less than the total volume of exemplary CNT growth zone **108** having a rectangular cross-section. In an equivalent growth cylindrical chamber (e.g., a cylindrical chamber having a width that accommodates the same planarized fiber as the rectangular cross-section CNT growth zone **108**), the volume of the fiber is 17,500 times less than the volume of CNT growth zone **108.** Although gas deposition processes (e.g., CVD, etc.) are typically governed by pressure and temperature alone, volume has a significant impact on the *efficiency* of deposition. With illustrative rectangular CNT growth zone **108** there is quite a bit of excess volume-volume in which unwanted reactions occur (e.g., gasses reacting with themselves or with chamber walls); and a cylindrical chamber has about eight times *that* volume. Due to this greater opportunity for competing reactions to occur, the desired reactions effectively occur more slowly in a cylindrical chamber, which is problematic for the development of a continuous process. Additionally, it is notable that when using a cylindrical chamber, more feed gas is required to provide the same flow percent as in the illustrative CNT growth zones having a rectangular cross-section. Another problem with the conventional circular cross-section is temperature distribution. When a relatively small-diameter chamber is used, the temperature gradient from the center of the chamber to the walls thereof is minimal. But with increased size, such as would be required for commercial-scale production, the temperature gradient increases. Such temperature gradients result in product quality variations across a substrate. (i.e., product quality varies as a function of radial position). This problem is substantially avoided when using CNT growth zone **108** having a cross-section more closely matched to corresponding substrate **106** (e.g., rectangular). In particular, when a planar substrate is used, CNT growth zone **108** can have a height maintained constant as the size of substrate **106** scales upward. Temperature gradients between the top and bottom of CNT growth zone **108** are essentially negligible and, consequently, thermal issues and the product-quality variations that result are avoided.

The conventional circular cross-sectional chamber also requires feed gas introduction. Because tubular furnaces are used, conventional CNT synthesis chambers introduce feed gas at one end and draw it through the chamber to the other end. In the illustrative embodiment disclosed herein, feed gas is introduced at the center of or within CNT growth zone **108** (symmetrically, either through the sides or through the top and bottom plates of CNT growth zone **108**). This improves the overall CNT growth rate because the incoming feed gas in continuously replenishing at the hottest portion of the system, which is where CNT growth is most active. This constant feed gas replenishment can be an important aspect to the increased growth rate exhibited by CNT growth zone(s) **108** in accordance with the present teachings.

When hot feed gas mixes with the external environment, degradation of the substrate material (e.g., fiber) would increase. Conventional CNT synthesis processes typically require that the substrate is carefully (and slowly) cooled. Purge zones **114, 116** on either or both ends of CNT growth zone **108** disclosed herein provide a buffer between the internal system and external environments. Purge zone **116** achieves the cooling in a short period of time, as may be required for the continuous processing line.

The use of metal (e.g., stainless steel) in accordance with the illustrative embodiment is uncommon and, in fact, counterintuitive. Metal, and stainless steel in particular, is more susceptible to carbon deposition (i.e., soot and by-product formation). Quartz, on the other hand, is easier to clean, with fewer deposits. Quartz also facilitates sample observation. However, the increased soot and carbon deposition on stainless steel can result in more consistent, faster, more efficient, and more stable CNT growth. It is believed that, in conjunction with atmospheric operation, the CVD process occurring in CNT growth zone **108** is diffusion limited. That is, the catalyst is "overfed;" too much carbon is available in the system due to its relatively higher partial pressure (than if operating under partial vacuum). As a consequence, in an open system - especially a clean one - too much carbon can adhere to catalyst particles, compromising their ability to synthesize CNTs. In accordance with the illustrative embodiment, the inventors thus intentionally run the apparatus "dirty." Once carbon deposits to a monolayer on the walls of CNT growth zone **108,** carbon will readily deposit over itself. Since some of the available carbon is "withdrawn" due to this mechanism, the remaining carbon radicals react with the catalyst at a more acceptable rate - a rate that does not poison the catalyst. Existing systems run "cleanly" which, if they were open for continuous processing, would produce a much lower yield of CNTs at reduced growth rates.

Using apparatus **100** allows for both a catalyst reduction and CNT growth to occur within CNT growth zone **108.** This is significant because the reduction step cannot be accomplished timely enough for use in a continuous process if performed as a discrete operation. Conventionally, the reduction step typically takes 1-12 hours to perform. Both operations occur in CNT growth zone **108** in accordance with the present invention due, at least in part, to the fact that feed gas is introduced the center of CNT growth zone **108,** not the end. The reduction process occurs as the fibers enter the heated zone; by this point, the gas has had time to react with the walls and cool off prior to reacting with the catalyst and causing the oxidation reduction (via hydrogen radical interactions). It is this transition region where the reduction occurs. At the hottest isothermal zone in the system, the CNT growth occurs, with the greatest growth rate occurring proximal to the feed gas inlets near the center of the CNT growth zone.

The illustrative embodiments can be used with any type of substrate. The term "substrate" is intended to include any material upon which CNTs can be synthesized and can include, but is not limited to, a carbon fiber, a graphite fiber, a cellulosic fiber, a glass fiber, a metal fiber (e.g., steel, aluminum, etc.), a metallic fiber, a ceramic fiber, a metallic-ceramic fiber, an aramid fiber, or any substrate comprising a combination thereof. The substrate can include fibers or filaments arranged, for example, in a fiber tow (typically having about 1000 to about 12000 fibers) as well as planar substrates such as fabrics, tapes, or other fiber broadgoods, and materials upon which CNTs can be synthesized.

In some embodiments, the apparatus of the present invention results in the production of carbon-nanotube *infused* fiber. As used herein, the term "infused" means chemically or physically bonded and "infusion" means the process of bonding. Such bonding can involve direct covalent bonding, ionic bonding, pi-pi, and/or van der Waals force-mediated physisorption. For example, in some embodiments, the CNTs can be directly bonded to the substrate. Additionally, it is believed that some degree of mechanical interlocking occurs as well. Bonding can be indirect, such as the CNT infusion to the substrate via a barrier coating and/or an intervening transition metal nanoparticle disposed between the CNTs and substrate. In the CNT-infused substrates disclosed herein, the carbon nanotubes can be "infused" to the substrate directly or indirectly as described above. The particular manner in which a CNT is "infused" to a substrate is referred to as a "bonding motif."

CNTs useful for infusion to substrates include single-walled CNTs, double-walled CNTs, multi-walled CNTs, and mixtures thereof. The exact CNT to be used depends on the application of the CNT-infused substrate. CNTs can be used for thermal and/or electrical conductivity applications, or as insulators. In some embodiments, the infused carbon nanotubes are single-wall nanotubes. In some embodiments, the infused carbon nanotubes are multi-wall nantotubes. In some embodiments, the infused carbon nanotubes are a combination of single-wall and multi-wall nanotubes. There are some differences in the characteristic properties of single-wall and multi-wall nanotubes that, for some end uses of the fiber, dictate the synthesis of one or the other type of nanotube. For example, single-walled nanotubes can be semi-conducting or metallic, while multi-walled nanotubes are metallic.

As is clear from the foregoing, two key distinctions between conventional chambers and illustrative apparatus and method are: catalyst reduction time and CNT synthesis time. In the illustrative methods, these operations take seconds, rather than several minutes to hours as per conventional systems. The inability of conventional chambers to control catalyst-particle chemistry and geometry results in processes that include multiple time-consuming sub operations that can only be performed in batchwise fashion.

In a variation of the illustrative embodiment, the continuous processing line for CNT growth is used to provide an improved filament winding process. In this variation, CNTs are formed on substrates (e.g., graphite tow, glass roving, etc.) using the system and process described above, and are then passed through a resin bath to produce resin-impregnated, CNT-infused substrate. After resin impregnation, the substrate is positioned on the surface of a rotating mandrel by a delivery head. The substate then winds onto the mandrel in a precise geometric pattern in known fashion. These additional sub operations can be performed in continuous fashion, extending the basic continuous process.

The filament winding process described above provides pipes, tubes, or other forms as are characteristically produced via a male mold. But the forms made from the filament winding process disclosed herein differ from those produced via conventional filament winding processes. Specifically, in the process disclosed herein, the forms are made from composite materials that include CNT-infused substrates. Such forms will therefore benefit from enhanced strength, etc., as provided by the CNT-infused substrates.

As used herein the term "spoolable dimensions" refers to substrates having at least one dimension that is not limited in length, allowing for the material to be stored on a spool or mandrel. Substrates of "spoolable dimensions" have at least one dimension that indicates the use of either batch or continuous processing for CNT infusion as described herein. One substrate of spoolable dimensions that is commercially available is exemplified by AS4 12k carbon fiber tow with a tex value of 800 (1 tex = I g/1,000m) or 620 yard/lb (about 567 m/0.454 kg) (Grafil, Inc., Sacramento, CA). Commercial carbon fiber tow, in particular, can be obtained in 5, 10, 20, 50, and 100 lb (about 2.27, 4.54, 9.07, 22.68 and 45.36 kg). (for spools having high weight, usually a 3k/12K tow) spools, for example, although larger spools may require special order. Processes of the invention operate readily with 5 to 20 lb (about 2.27 to 9.07 kg) spools, although larger spools are usable. Moreover, a pre-process operation can be incorporated that divides very large spoolable lengths, for example 100 lb (about 45.36 kg) or more, into easy to handle dimensions, such as two 50 lb (about 22.68 kg) spools.

As used herein, the term "feed gas" refers to any carbon compound gas, solid, or liquid that can be volatilized, nebulized, atomized, or otherwise fluidized and is capable of dissociating or cracking at high temperatures into at least some free carbon radicals and which, in the presence of a catalyst, can form CNTs on the substrate. In some embodiments, feed gas can comprise acetylene, ethylene, methanol, methane, propane, benzene, natural gas, or any combination thereof.

As used herein, the term "purge gas" refers to any gas, solid, or liquid that can be volatilized, nebulized, atomized, or otherwise fluidized and is capable of displacing another gas. Purge gas can optionally be cooler than corresponding feed gas. In some embodiments, purge gas can include a mass flow controlled mixture of inert gas such as nitrogen, argon, or helium and carbon feedstock, such as acetylene, ethylene, ethane, methane, carbon monoxide, and similar carbon-containing gases, typically mixed from between about 0 to about 10% feed gas with the remainder consisting of inert gas. In other embodiments, however, additional gases such as ammonia, hydrogen, and/or oxygen can be mixed as a third process gas as well in ranges of between about 0 to about 10%.

As used herein, the term "nanoparticle" or NP (plural NPs), or grammatical equivalents thereof refers to particles sized between about 0.1 to about 100 nanometers in equivalent spherical diameter, although the NPs need not be spherical in shape. Transition metal NPs, in particular, serve as catalysts for CNT growth on the substrates.

As used herein, the term "material residence time" refers to the amount of time a discrete point along a substrate of spoolable dimensions is exposed to CNT growth conditions during the CNT infusion processes described herein. This definition includes the residence time when employing multiple CNT growth zones.

As used herein, the term "linespeed" refers to the speed at which a substrate of spoolable dimensions can be fed through the CNT infusion processes described herein, where linespeed is a velocity determined by dividing CNT growth zone(s) length by the material residence time.

It is to be understood that the above-described embodiments are merely illustrative of the present invention and that many variations of the above-described embodiments can be devised by those skilled in the art without departing from the scope defined in the claims. For example, in this Specification, numerous specific details are provided in order to provide a thorough description and understanding of the illustrative embodiments of the present invention. Those skilled in the art will recognize, however, that the invention can be practiced without one or more of those details, or with other processes, materials, components, etc.

Furthermore, in some instances, well-known structures, materials, or operations are not shown or described in detail to avoid obscuring aspects of the illustrative embodiments. It is understood that the various embodiments shown in the Figures are illustrative, and are not necessarily drawn to scale. Reference throughout the specification to "one embodiment" or "an embodiment" or "some embodiments" means that a particular feature, structure, material, or characteristic described in connection with the embodiment(s) is included in at least one embodiment of the present invention, but not necessarily all embodiments. Consequently, the appearances of the phrase "in one embodiment," "in an embodiment," or "in some embodiments" in various places throughout the Specification are not necessarily all referring to the same embodiment. Furthermore, the particular features, structures, materials, or characteristics can be combined in any suitable manner in one or more embodiments.

## Claims

1. An apparatus comprising:
a first end having a substrate inlet sized to allow a spoolable length substrate to pass therethrough, wherein the substrate includes any material upon which carbon nantotubes can be synthesized and has at least one dimension that is not limited in length;
a preheated first purge zone comprising a purge gas inlet;
a cooled second purge zone comprising a purge gas inlet;
at least one carbon nanotube growth zone disposed between the first and second purge zone;
at least one heater in thermal communication with the carbon nanotube growth zone heating the carbon nanotube growth zone such that the temperature is in the range of 550°C to 850°C;
and at least one feed gas inlet in fluid communication with the carbon nanotube growth zone and proximate to the center of the carbon nanotube growth zone; wherein the apparatus is open to the atmosphere during operation;
a second end having a substrate outlet sized to allow the spoolable length substrate to pass out therethrough;
wherein within the carbon nanotube growth zone a catalyst reduction and carbon nanotube growth occur.

2. The apparatus of claim 1, wherein the reduction process occurs as the substrate enters the heated carbon nanotube growth zone and the carbon nanotube growth occurs at its greatest growth rate proximal to the at least one feed gas inlet, the at least one feed gas inlet being located proximate to the center of the carbon nanotube growth zone.

3. The apparatus of claim 1, wherein the feed gas inlet is in the carbon nanotube growth zone.

4. The apparatus according to any of the preceding claims, further comprising one or more exhaust ports being placed between purge zones and carbon nanotube growth zone.

5. The apparatus of claim 1, wherein a cross sectional area of the carbon nanotube growth zone is no greater than 10000 times a cross sectional area of the spoolable length substrate.

6. The apparatus according to any of the preceding claims, wherein the carbon nanotube growth zone is rectangular.

7. The apparatus according to any of the preceding claims, wherein the carbon nanotube growth zone is formed by a metal enclosure.

8. The apparatus according to the preceding claims, wherein the metal comprises stainless steels

9. The apparatus of claim 1, wherein the carbon nanotube growth zone has an internal volume no greater than 10000 times a volume of a section of the spoolable length substrate; wherein the section of the spoolable length substrate has a length substantially equal to the length of the carbon nanotube growth zone.

10. A method comprising:
providing an apparatus comprising a first end having a substrate inlet sized to allow a spoolable length substrate to pass therethrough;
a preheated first purge zone comprising a purge gas inlet;
a cooled second purge zone comprising a purge gas inlet;
at least one carbon nanotube growth zone disposed between the first and second purge zone;
at least one heater in thermal communication with the carbon nanotube growth zone;
and at least one feed gas inlet in fluid communication with the carbon nanotube growth zone and proximate to the center of the carbon nanotube growth zone; wherein the apparatus is open to the atmosphere during operation;
a second end having a substrate outlet sized to allow the spoolable length substrate to pass out therethrough;
providing a substrate wherein the substrate includes any material upon which carbon nantotubes can be synthesized and has at least one dimension that is not limited in length;
introducing a portion of the substrate into carbon nanotube growth zone via the inlet;
heating the carbon nanotube growth zone to a temperature in the range of 550°C to 850°C;
introducing a feed gas into the carbon nanotube growth zone; and
passing the portion of the substrate through the carbon nanotube growth zone, such that carbon nanotubes form on the portion of the substrate wherein within the carbon nanotube growth zone a catalyst reduction and carbon nanotube growth occur.

11. The method of claim 10, comprising removing the portion of the substrate and carbon nanotubes formed thereon from the carbon nanotube growth zone.

12. The method of claim 10, wherein the first purge zone is purged prior to introducing the portion of the substrate into the carbon nanotube growth zone.

13. The method of claim 10, further comprising preheating the feed gas prior to introducing the feed gas into the carbon nanotube growth zone.

14. The method of claim 12, wherein the second purge zone is purged after the portion of the substrate has passed through the carbon nanotube growth zone.

15. The method of claim 10, the method comprising continuously passing the spoolable length substrate through the apparatus.

## Patentansprüche

1. Vorrichtung, umfassend:
ein erstes Ende mit einem Substrateinlass, der in der Größe so bemessen ist, dass ein Substrat spulfähiger Länge durch ihn hindurchgeführt werden kann, wobei das Substrat jegliches Material umfasst, auf dem Kohlenstoffnanoröhrchen synthetisiert werden können, und mindestens eine Dimension aufweist, die in der Länge nicht begrenzt ist;
eine vorgewärmte, erste Spülzone, die einen Spülgaseinlass aufweist;
eine gekühlte, zweite Spülzone, die einen Spülgaseinlass aufweist;
mindestens eine Kohlenstoffnanoröhrchen-Wachstumszone, die zwischen der ersten und zweiten Spülzone angeordnet ist;
mindestens eine Heizeinrichtung, die in thermischer Verbindung mit der Kohlenstoffnanoröhrchen-Wachstumszone steht und die Kohlenstoffnanoröhrchen-Wachstumszone so erwärmt, dass die Temperatur im Bereich von 550°C bis 850°C liegt;
und mindestens einen Beschickungsgaseinlass, der in Fluidverbindung mit der Kohlenstoffnanoröhrchen-Wachstumszone steht und sich nahe der Mitte der Kohlenstoffnanoröhrchen-Wachstumszone befindet; wobei die Vorrichtung im Betrieb zur Atmosphäre hin offen ist;
ein zweites Ende mit einem Substratauslass, der in der Größe so bemessen ist, dass das Substrat spulfähiger Länge durch ihn hindurch herausgeführt werden kann;
wobei innerhalb der Kohlenstoffnanoröhrchen-Wachstumszone eine Katalysatorreduktion und ein Wachstum von Kohlenstoffnanoröhrchen erfolgen.

2. Vorrichtung nach Anspruch 1, wobei der Reduktionsprozess erfolgt, wenn das Substrat in die erwärmte Kohlenstoffnanoröhrchen-Wachstumszone eintritt, und das Wachstum der Kohlenstoffnanoröhrchen proximal zum mindestens einen Beschickungsgaseinlass mit seiner größten Wachstumsrate erfolgt, wobei sich der mindestens eine Beschickungsgaseinlass nahe der Mitte der Kohlenstoffnanoröhrchen-Wachstumszone befindet.

3. Vorrichtung nach Anspruch 1, wobei der Beschickungsgaseinlass in der Kohlenstoffnanoröhrchen-Wachstumszone liegt.

4. Vorrichtung nach einem der vorhergehenden Ansprüche, welche darüber hinaus eine oder mehrere zwischen Spülzonen und der Kohlenstoffnanoröhrchen-Wachstumszone angeordnete Abluftöffnungen aufweist.

5. Vorrichtung nach Anspruch 1, wobei eine Querschnittsfläche der Kohlenstoffnanoröhrchen-Wachstumszone nicht größer als das 10.000-fache Maß einer Querschnittsfläche des Substrats spulfähiger Länge ist.

6. Vorrichtung nach einem der vorhergehenden Ansprüche, wobei die Kohlenstoffnanoröhrchen-Wachstumszone rechteckig ist.

7. Vorrichtung nach einem der vorhergehenden Ansprüche, wobei die Kohlenstoffnanoröhrchen-Wachstumszone durch eine metallische Einhausung gebildet ist.

8. Vorrichtung nach einem der vorhergehenden Ansprüche, wobei das Metall rostfreien Stahl umfasst.

9. Vorrichtung nach Anspruch 1, wobei die Kohlenstoffnanoröhrchen-Wachstumszone ein Innenvolumen von nicht mehr als dem 10.000-fachen Maß eines Volumens eines Teilstücks des Substrats spulfähiger Länge hat; wobei das Teilstück des Substrats spulfähiger Länge eine Länge hat, die im Wesentlichen gleich der Länge der Kohlenstoffnanoröhrchen-Wachstumszone ist.

10. Verfahren, umfassend:
Bereitstellen einer Vorrichtung mit einem ersten Ende, das einen Substrateinlass aufweist, der in der Größe so bemessen ist, dass ein Substrat spulfähiger Länge durch ihn hindurchdurchgeführt werden kann;
eine vorgewärmte, erste Spülzone, die einen Spülgaseinlass aufweist;
eine gekühlte, zweite Spülzone, die einen Spülgaseinlass aufweist;
mindestens eine Kohlenstoffnanoröhrchen-Wachstumszone, die zwischen der ersten und zweiten Spülzone angeordnet ist;
mindestens eine Heizeinrichtung, die in thermischer Verbindung mit der Kohlenstoffnanoröhrchen-Wachstumszone steht;
und mindestens einen Beschickungsgaseinlass, der in Fluidverbindung mit der Kohlenstoffnanoröhrchen-Wachstumszone steht und sich nahe der Mitte der Kohlenstoffnanoröhrchen-Wachstumszone befindet; wobei die Vorrichtung im Betrieb zur Atmosphäre hin offen ist;
ein zweites Ende mit einem Substratauslass, der in der Größe so bemessen ist, dass das Substrat spulfähiger Länge durch ihn hindurch herausgeführt werden kann;
Bereitstellen eines Substrats, wobei das Substrat jegliches Material umfasst, auf dem Kohlenstoffnanoröhrchen synthetisiert werden können, und mindestens eine Dimension aufweist, die in der Länge nicht begrenzt ist;
Einführen eines Abschnitts des Substrats in die Kohlenstoffnanoröhrchen-Wachstumszone über den Einlass;
Erwärmen der Kohlenstoffnanoröhrchen-Wachstumszone auf eine Temperatur im Bereich von 550°C bis 850°C;
Einleiten eines Beschickungsgases in die Kohlenstoffnanoröhrchen-Wachstumszone; und Hindurchführen des Abschnitts des Substrats durch die Kohlenstoffnanoröhrchen-Wachstumszone, derart, dass sich Kohlenstoffnanoröhrchen auf dem Abschnitt des Substrats bilden, wobei innerhalb der Kohlenstoffnanoröhrchen-Wachstumszone eine Katalysatorreduktion und ein Wachstum von Kohlenstoffnanoröhrchen erfolgen.

11. Verfahren nach Anspruch 10, umfassend Entfernen des Abschnitts des Substrats und der darauf gebildeten Kohlenstoffnanoröhrchen aus der Kohlenstoffnanoröhrchen-Wachstumszone.

12. Verfahren nach Anspruch 10, wobei die erste Spülzone gespült wird, bevor der Abschnitt des Substrats in die Kohlenstoffnanoröhrchen-Wachstumszone eingeführt wird.

13. Verfahren nach Anspruch 10, darüber hinaus umfassend Vorwärmen des Beschickungsgases bevor es in die Kohlenstoffnanoröhrchen-Wachstumszone eingeleitet wird.

14. Verfahren nach Anspruch 12, wobei die zweite Spülzone gespült wird, nachdem der Abschnitt des Substrats die Kohlenstoffnanoröhrchen-Wachstumszone durchwandert hat.

15. Verfahren nach Anspruch 10, wobei das Substrats spulfähiger Länge kontinuierlich durch die Vorrichtung läuft.

## Revendications

1. Appareil comprenant :
une première extrémité présentant une entrée de substrat dimensionnée pour permettre à un substrat à longueur enroulable de passer au travers, sachant que le substrat inclut n'importe quel matériau sur lequel des nanotubes de carbone peuvent être synthétisés et présente au moins une dimension qui n'est pas limitée en longueur ;
une première zone de purge préchauffée comprenant une entrée de gaz de purge ;
une deuxième zone de purge refroidie comprenant une entrée de gaz de purge ;
au moins une zone de croissance de nanotubes de carbone disposée entre la première et la deuxième zone de purge ;
au moins un dispositif de chauffage en communication thermique avec la zone de croissance de nanotubes de carbone, chauffant la zone de croissance de nanotubes de carbone de telle façon que la température soit située dans la plage de 550 °C à 850 °C ;
et au moins une entrée de gaz d'alimentation en communication fluidique avec la zone de croissance de nanotubes de carbone et proche du centre de la zone de croissance de nanotubes de carbone ; sachant que l'appareil est ouvert vers l'atmosphère pendant le fonctionnement ;
une deuxième extrémité présentant une sortie de substrat dimensionnée pour permettre au substrat à longueur enroulable de sortir en passant au travers ;
sachant que, à l'intérieur de la zone de croissance de nanotubes de carbone, une réduction catalytique et une croissance de nanotubes de carbone ont lieu.

2. L'appareil de la revendication 1, dans lequel le processus de réduction a lieu lorsque le substrat entre dans la zone de croissance de nanotubes de carbone chauffée et la croissance de nanotubes de carbone a lieu à son plus grand taux de croissance près de l'au moins une entrée de gaz d'alimentation, l'au moins une entrée de gaz d'alimentation étant située près du centre de la zone de croissance de nanotubes de carbone.

3. L'appareil de la revendication 1, dans lequel l'entrée de gaz d'alimentation est située dans la zone de croissance de nanotubes de carbone.

4. L'appareil selon l'une quelconque des revendications précédentes, comprenant en outre un ou plusieurs orifices d'échappement placés entre les zones de purge et la zone de croissance de nanotubes de carbone.

5. L'appareil de la revendication 1, dans lequel une aire de section transversale de la zone de croissance de nanotubes de carbone n'est pas plus grande que 10 000 fois une aire de section transversale du substrat à longueur enroulable.

6. L'appareil selon l'une quelconque des revendications précédentes, dans lequel la zone de croissance de nanotubes de carbone est rectangulaire.

7. L'appareil selon l'une quelconque des revendications précédentes, dans lequel la zone de croissance de nanotubes de carbone est formée par une enceinte de métal.

8. L'appareil selon les revendications précédentes, dans lequel le métal comprend de l'acier inoxydable.

9. L'appareil de la revendication 1, dans lequel la zone de croissance de nanotubes de carbone présente un volume interne qui n'est pas supérieur à 10 000 fois un volume d'une section du substrat à longueur enroulable ; sachant que la section du substrat à longueur enroulable a une longueur sensiblement égale à la longueur de la zone de croissance de nanotubes de carbone.

10. Procédé comprenant :
la mise à disposition d'un appareil comprenant une première extrémité présentant une entrée de substrat dimensionnée pour permettre à un substrat à longueur enroulable de passer au travers ;
une première zone de purge préchauffée comprenant une entrée de gaz de purge ;
une deuxième zone de purge refroidie comprenant une entrée de gaz de purge ;
au moins une zone de croissance de nanotubes de carbone disposée entre la première et la deuxième zone de purge ;
au moins un dispositif de chauffage en communication thermique avec la zone de croissance de nanotubes de carbone ;
et au moins une entrée de gaz d'alimentation en communication fluidique avec la zone de croissance de nanotubes de carbone et proche du centre de la zone de croissance de nanotubes de carbone ; sachant que l'appareil est ouvert vers l'atmosphère pendant le fonctionnement ;
une deuxième extrémité présentant une sortie de substrat dimensionnée pour permettre au substrat à longueur enroulable sortir en passant au travers ;
la mise à disposition d'un substrat, sachant que le substrat inclut n'importe quel matériau sur lequel des nanotubes de carbone peuvent être synthétisés et présente au moins une dimension qui n'est pas limitée en longueur ;
l'introduction d'une partie du substrat dans la zone de croissance de nanotubes de carbone via l'entrée ;
le chauffage de la zone de croissance de nanotubes de carbone à une température située dans la plage de 550 °C à 850 °C ;
l'introduction d'un gaz d'alimentation dans la zone de croissance de nanotubes de carbone ; et
le fait de faire passer la partie du substrat à travers la zone de croissance de nanotubes de carbone, de façon que des nanotubes de carbone se forment sur la partie du substrat, sachant que, à l'intérieur de la zone de croissance de nanotubes de carbone, une réduction catalytique et une croissance de nanotubes de carbone ont lieu.

11. Le procédé de la revendication 10, comprenant le fait d'enlever la partie du substrat et les nanotubes de carbone formés dessus de la zone de croissance de nanotubes de carbone.

12. Le procédé de la revendication 10, dans lequel la première zone de purge est purgée avant l'introduction de la partie du substrat dans la zone de croissance de nanotubes de carbone.

13. Le procédé de la revendication 10, comprenant en outre le préchauffage du gaz d'alimentation avant l'introduction du gaz d'alimentation dans la zone de croissance de nanotubes de carbone.

14. Le procédé de la revendication 12, dans lequel la deuxième zone de purge est purgée après que la partie du substrat a passé à travers la zone de croissance de nanotubes de carbone.

15. Le procédé de la revendication 10, le procédé comprenant le fait de faire passer en continu le substrat à longueur enroulable à travers l'appareil.
